# EUROPEAN PATENT APPLICATION

(11) **EP 2 020 683 A1**
(43) Date of publication of application: **04.02.2009**
(21) Application number: 07707889.7
(22) Date of filing: 01.02.2007
(51) Int. Cl.: H01L 23/36, H01L 25/07, H01L 25/11, H01L 25/18

(54) **SEMICONDUCTOR DEVICE AND METHOD FOR MANUFACTURING SAME**

(30) Priority: 10.05.2006 JP 2006131083
(71) Applicant: Kabushiki Kaisha Toshiba, Minato-ku, Tokyo 105-8001 (JP)
(72) Inventor: SEKIYA, Hiroki c/o Intellectual Property Division, Minatu-ku, Tokyo (JP); OOBU, Toshiharu c/o Intellectual Property Division, Minatu-ku, Tokyo (JP); MORIKAWA, Ryuichi c/o Intellectual Property Division, Minatu-ku, Tokyo (JP); NINOMIYA, Gou c/o Intellectual Property Division, Minatu-ku, Tokyo (JP); HIRAMOTO, Hiroyuki c/o Intellectual Property Division, Minatu-ku, Tokyo (JP)
(74) Representative: HOFFMANN EITLE
(86) International application number: PCT/JP2007/051703
(87) International publication number: WO 2007/129486

(57) **Abstract**

A semiconductor device includes: a semiconductor element (106) having a surface on a positive electrode side and a surface on a negative electrode side; multiple conductors (13 to 15) bonded respectively to the surface on the positive electrode side and to the surface on the negative electrode side of the semiconductor element; a heat sink plate (11) disposed as intersecting a junction interface between the semiconductor element and each of the multiple conductors and configured to discharge heat of the semiconductor element; and an insulator (12) bonding the heat sink plate to the multiple conductors. The insulator includes a heat conductive insulator (16) disposed inside a portion facing all of the multiple conductors and a flexible insulator (17) disposed at a portion other than the heat conductive insulator.

## Description

### Technical Field

The present invention relates to a semiconductor device and a method for manufacturing the same, or more specifically, to a technique of cooling a power semiconductor device such as a power transistor, a thyristor, a power module or a power IC to be used in an inverter.

### Background Art

Power semiconductor devices including power ICs and power modules, which are collectively referred to as power devices, are used in, for example, home electric appliances, energy saving direct drives or intelligent actuators, and inverter controlled power appliances for driving vehicle motors and the like.

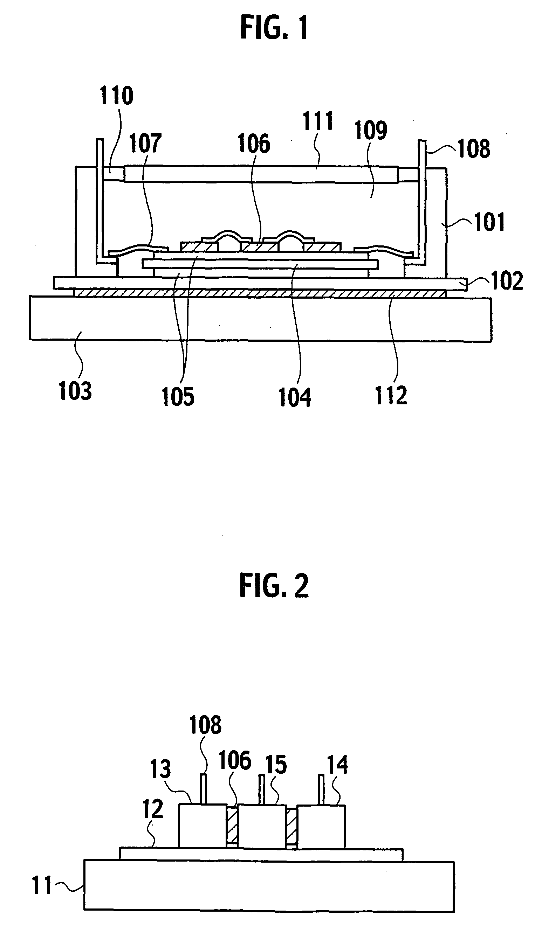

FIG. 1 is a cross-sectional view showing a structure of a conventional typical semiconductor device. Generally, a resin case 101 made of resin such as polyphenylene sulfide or polybutylene terephthalate is combined with a heat sink plate 102 made of metal such as copper, a copper alloy or a metal-matrix composite, to form a container on this semiconductor device. Inside the container, components including a semiconductor element are housed. The heat sink plate 102 is further attached to a cooler 103 with a heat conductive grease 112 in between. Adhesion to the heat conductive grease 112 is maintained by screwing the heat sink plate 102 and the cooler 103 together.

An insulation substrate 104 is soldered onto the heat sink plate 102. Then, semiconductor elements 106 and bonding wires 107 serving as circuit components are disposed through conductive foils 105 on the insulation substrate 104. An external connection terminal 108 is further provided. One end of the external connection terminal 108 is connected to the semiconductor element 106 through the bonding wire 107 while the other end is drawn out. Moreover, sealing resin 109 made of silicone gel, epoxy resin or other resin materials is filled inside the resin case 101. The sealing resin 109 is further sealed with solid resin 110 such as epoxy resin, and a terminal holder 111 made of either the same material as or a different material from the resin case is fixed onto this solid resin 110. In some cases, alternatively, the solid resin 110 is omitted, and the terminal holder 111 is disposed on the entire surface of the resin case 101 as a lid. With this structure, a semiconductor device having relatively excellent electric characteristics and reliability is achieved.

Incidentally, if a power semiconductor device has the semiconductor element 106 operating at a high temperature in excess of 100°C, and is used at a high voltage (kV class), a material used as the insulation substrate 104, which is provided between the semiconductor element 106 and the heat sink plate 102, needs to be able to release heat generated by the semiconductor element 106 promptly to the heat sink plate 102 and needs to have a high insulation property. For this reason, in the conventional semiconductor device shown in FIG. 1, a material made of a ceramic such as aluminum nitride having excellent heat conductivity and insulation property is used as the insulation substrate 104. Then, it is configured so that the heat is efficiently released from the heat sink plate 102 to the cooler 103 by interposing the heat conductive grease 112 between the heat sink plate 102 and the cooler 103.

In the conventional semiconductor device configured as described above, the heat conductive grease 112 is interposed between the heat sink plate 102 and the cooler 103, and the heat sink plate 102 is pressurized and attached onto the cooler 103 by means of fitting screws provided around the semiconductor device. However, there has been a problem that a pressurizing force becomes uneven and contact thermal resistance thereby becomes uneven when forces to tighten the screws come to differ from one another and when any of or both of the heat sink plate 102 and the cooler 103 become deformed, for example.

Meanwhile, having a small thickness and a small heat capacity, the insulation substrate 104 cannot be expected to produce an effect of diffusing the heat generated by the semiconductor element 106. In this context, there has been a problem as follows. The temperature of the semiconductor element 106 rises particularly when the semiconductor device is initiated. At this time, the thermal resistance becomes large during a transitional period, thereby raising a transitional temperature. Moreover, another problem is that, when the contact thermal resistance is temporarily increased between the heat sink plate 102 and the cooler 103 as described previously, the temperature rises significantly, which leads to degradation in cooling efficiency.

In addition, there is a large difference between a linear expansion coefficient of the insulation substrate 104 made of the ceramic and a linear expansion coefficient of the heat sink plate 102 made of the metal. For this reason, the heat sink plate 102 becomes deformed because of the difference in the thermal expansion associated with the heat generation at the time of operating the semiconductor device. Accordingly, a distance between the heat sink plate 102 and the cooler 103 is expanded to have a thickness more than a coating thickness of the heat conductive grease at the time of assembly. Then, the deformation returns to the initial distance when the operation is stopped or less heat is generated. These actions occur repeatedly. By this repetition of expansion and contraction, there is observed a phenomenon that the heat conductive grease 112 is gradually squeezed out from a contact surface. As a consequence, the amount of the heat conductive grease 112 between the heat sink plate 102 and the cooler 103 becomes insufficient. This causes a problem that the contact thermal resistance is significantly increased, thereby leading to thermal runaway of the semiconductor element 106.

To avoid these various problems, JP-A 2005-348529 discloses an inverter device which is capable of improving a current-carrying capacity and downsizing of an inverter device by improving cooling efficiency of a power semiconductor device, and which also has excellent productivity. FIG. 2 is a cross-sectional view showing a structure of a portion where semiconductor element is mounted on the semiconductor device disclosed in JP-A 2005-348529. In this semiconductor device, multiple semiconductor elements 106 are soldered to multiple conductors 13 to 15, and the conductors 13 to 15 are bonded to a heat sink plate 11 through an insulator 12.

In this semiconductor device disclosed in JP-A 2008-348529, the conductors 13 to 15 are bonded directly to the heat sink plate 11 through the sheet-like insulator 12. Accordingly, unlike the above-described conventional semiconductor device, an increase in the contact thermal resistance does not occur, while the thermal resistance is reduced by half. Moreover, since the semiconductor element is cooled down from both surfaces, it is possible to achieve a cooling effect twice as large as that achieved in the above-described conventional semiconductor device. Further, since a thermal time constant becomes greater due to a heat capacity effect owing to thicknesses of the conductors 13 to 15, the transitional thermal resistance is reduced, and an effect to suppress the temperature rise at the time of initiation is also obtained. Thus, a total cooling performance is significantly improved.

### Disclosure of the Invention

However, the semiconductor device disclosed in JP-A 2005-348529 has the following problem. Specifically, the temperatures of the conductors 13 to 15 rise due to the heat generation by the semiconductor element 106 at the time of initiating the semiconductor device. However, there is a problem that the expansions and deformations of the conductors 13 to 15 due to this temperature rise act, as repetitive heat stresses, on the solder for bonding the semiconductor element 106 to the conductors 13 to 15 and on the insulator 12 provided between the conductors 13 to 15 and the heat sink plate 11, leading to reduction in the life of junctions between the conductors 13 to 15 and the semiconductor element 106, and between the conductors 13 to 15 and the insulator 12.

An object of the present invention is to provide a semiconductor device having excellent reliability and a method for manufacturing method the semiconductor device by improving a cooling performance to enhance durability.

A first invention is a semiconductor device including: a semiconductor element having a surface on a positive electrode side and a surface on a negative electrode side; a plurality of conductors bonded respectively to the surface on the positive electrode side and to the surface on the negative electrode side of the semiconductor element; a heat sink plate disposed as intersecting a junction interface between the semiconductor element and each of the plurality of conductors and configured to discharge heat of the semiconductor element; and an insulator bonding the heat sink plate to the plurality of conductors. In the semiconductor element, the insulator includes a heat conductive insulator disposed inside a portion facing all of the plurality of conductors and a flexible insulator disposed at a portion other than the heat conductive insulator.

A second invention is according to the first invention, in which the heat conductive insulator is made of resin containing a heat conductive inorganic filler, and the flexible insulator is made of rubber-like elastic resin.

A third invention is according to the first invention, which includes an adhesive resin layer between the insulator and the plurality of conductors.

A fourth invention is according to the first invention, which includes insulating resin located around the plurality of conductors and configured to cover and fix the insulator.

A fifth invention is a semiconductor device including: a semiconductor element having a surface on a positive electrode side and a surface on a negative electrode side; a plurality of conductors bonded respectively to the surface on the positive electrode side and to the surface on the negative electrode side of the semiconductor element; a first heat sink plate disposed as intersecting a junction interface between the semiconductor element and each of the plurality of conductors and configured to discharge heat of the semiconductor element; a first insulator bonding the first heat sink plate to the plurality of conductors; a second heat sink plate located opposite to the first heat sink plate with the plurality of conductors sandwiched therebetween, and configured to discharge heat of the semiconductor element; and a second insulator bonding the second heat sink plate to the plurality of conductors.

A sixth invention is according to the fifth invention, which further includes a metal body connecting the first heat sink plate and the second heat sink plate so as to surround the plurality of conductors bonded to the semiconductor element.

A seventh invention of a method for manufacturing a semiconductor device according to the present invention includes a conductor bonding step of bonding a plurality of conductors respectively to a surface on a positive electrode side and a surface on a negative electrode side of a semiconductor element including the surface on the positive electrode side and the surface on the negative electrode side; and an insulation bonding step of bonding a heat sink plate to the plurality of conductors by use of an insulator, the heat sink plate disposed as intersecting a junction interface between the semiconductor element and the plurality of conductors and configured to discharge heat of the semiconductor element, and the insulator including an adhesive sheet which constitutes a heat conductive insulator, and a flexible insulator. In the method, in the insulation bonding step, after the plurality of conductors are attached, by use of the adhesive sheet, to the heat sink plate inside a portion in which all of the plurality of conductors face the heat sink plate, the flexible insulator is formed by injecting liquid resin to an outer peripheral portion of the adhesive sheet and by solidifying or hardening the liquid resin.

According to the present invention, it is possible to provide a semiconductor device having excellent reliability and a method for manufacturing the semiconductor device by improving a cooling performance and enhancing durability.

To be more precise, according to the first invention, since the heat conductive insulator is formed inside the portion facing all of the multiple conductors, the cooling performance can be improved. Since the flexible insulator is formed at the portion other than the heat conductive insulator where a stress applied to the insulator is particularly high, the durability can be improved by easing the stress. As a result, the reliability as a whole can be enhanced.

According to the second invention, since the resin containing the heat conductive inorganic filler is formed inside the portions respectively facing the multiple conductors, it is possible to improve the cooling performance. Since the rubber-like elastic resin is formed at the portion other than the heat conductive insulator where the stresses of the multiple conductors respectively acting on the insulator are particularly high, the stress is eased to thereby improve the durability. As a result, the reliability as a whole can be improved even more than that in the invention disclosed in claim 1.

According to the third invention, since the adhesive resin layer is provided between the insulator and the multiple conductors, it is possible to ease a difference in the state of stress on a junction interface between the insulator and the multiple conductors and thereby to establish uniformity as a whole. For this reason, it is possible to improve the durability against a temperature cycle attributable to heat generation of the semiconductor element, an external environment, and the like as well as the reliability.

According to the fourth invention, since the insulating resin for covering and fixing the insulator is provided around the multiple insulators, the insulating resin can ease a heat stress generated by the heat generation of the semiconductor element, and it is possible to improve the durability against the temperature cycle attributable to heat generation of the semiconductor element, the external environment, and the like as well as the reliability. Moreover, by insulating and sealing the insulator and the multiple conductors by using the insulating resin, penetration of moisture or impurities from outside can be prevented. Accordingly, it is possible to improve moisture resistance and the reliability of the semiconductor device.

According to the fifth invention, since the first heat sink plate and the second heat sink plate are disposed to face each other while sandwiching the multiple conductors, it is possible to establish stress balance by a symmetric structure in which the multiple conductors are located in the center. For this reason, it is possible to suppress thermal deformations of the heat sink plates in a manufacturing process or at the time of operating the semiconductor device, for example, and thereby to improve the durability against the temperature cycle attributable to heat generation of the semiconductor element, the external environment, and the like as well as the reliability.

According to the sixth invention, the metal body metal body connects the first heat sink plate and the second heat sink plate so as to surround the multiple conductors bonded to the semiconductor element, and this metal body functions as a radiator. Hence, the radiation effect can be enhanced even further. As a result, it is possible to suppress the thermal deformations of the heat sink plates and to improve the durability against the temperature cycle attributable to heat generation of the semiconductor element, the external environment, and the like as well as the reliability.

According to the seventh invention, after the multiple conductors are attached, by use of the adhesive sheet, to the heat sink plate inside a portion in which all of the plurality of conductors face the heat sink plate, the flexible insulator is formed by injecting liquid resin to an outer peripheral portion of the adhesive sheet and by solidifying or hardening the liquid resin. For this reason, it is possible to improve the reliability of the semiconductor device. Moreover, the manufacturing process is simplified and manufacturing time can be reduced. Accordingly, it is possible to improve mass productivity of the semiconductor device.

### Brief Description of the Drawings

[Fig. 1] FIG. 1 is a cross-sectional view showing a structure of a conventional typical semiconductor device.
[Fig. 2] FIG. 2 is a cross-sectional view showing a structure of a conventional semiconductor device disclosed in JP-A 2005-348529.
[Fig. 3] FIG. 3 is a cross-sectional view partially showing a structure of a semiconductor device according to Embodiment 1 of the present invention.
[Fig. 4] FIG. 4 is an external perspective view partially showing the structure of the semiconductor device according to Embodiment 1 of the present invention.
[Fig. 5] FIG. 5 is a graph showing comparison of thermal resistance characteristics among the semiconductor device according to Embodiment 1 of the present invention and other semiconductor devices.
[Fig. 6] FIG. 6 is a cross-sectional view partially showing a structure of a semiconductor device according to Embodiment 2 of the present invention.
[Fig. 7] FIG. 7 is a graph showing an elastic modulus characteristic of an insulator used in the semiconductor device according to Embodiment 2 of the present invention.
[Fig. 8] FIGs. 8(a) to 8(d) are views for explaining a method, according to Embodiment 3 of the present invention, for manufacturing a semiconductor device.
[Fig. 9] FIG. 9 is a cross-sectional view partially showing a structure of a semiconductor device according to Embodiment 4 of the present invention.
[Fig. 10] FIG. 10 is a cross-sectional view partially showing a structure of a semiconductor device according to Embodiment 5 of the present invention.
[Fig. 11] FIG. 11 is a cross-sectional view partially showing a structure of a semiconductor device according to Embodiment 6 of the present invention.

### Best Modes for Carrying Out the Invention

Now, embodiments of the present invention will be described below in detail with reference to the accompanying drawings. In the following, components having the same function are described while being designated by the same reference numerals. Moreover, it is to be noted that the drawings are schematic and therefore relations between thicknesses and flat dimensions, proportions, and the like are different from the actuality. Therefore, the concrete thicknesses and dimensions should be determined in consideration of the following description. Further, the drawings may include aspects having different dimensional relations and proportions.

### (Embodiment 1)

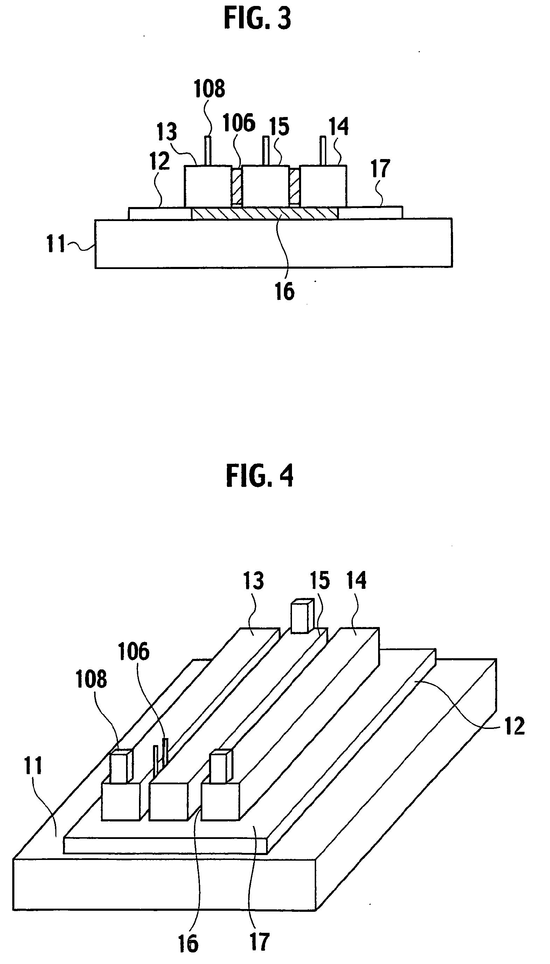

FIG. 3 is a cross-sectional view partially showing a structure of a semiconductor device according to Embodiment 1 of the present invention, and FIG. 4 is an external perspective view partially showing the structure of the semiconductor device. This semiconductor device includes semiconductor elements 106 each having a positive electrode side surface and a negative electrode side surface, a conductor 13 bonded to the positive electrode side of the semiconductor element 106, a conductor 14 bonded to the negative electrode side, and a conductor 15 provided in the middle of the conductor 13 and the conductor 14. Counting these semiconductor elements 106 and the conductors 13 to 15 as one phase, the semiconductor device is configured with three phases. Here, the conductor 15 in the middle may be omitted. The semiconductor elements 106 are disposed respectively between the conductors 13 and 15 while being bonded thereto.

A space between a heat sink plate 11 and the conductors 13 to 15 is connected by use of an insulator 12. The insulator 12 includes a heat conductive insulator 16 disposed inside a portion facing all of the conductors 13 to 15 and a flexible insulator 17 disposed at an outer peripheral portion of the conductors 13 to 15.

Metal such as copper is suitable for the material of the conductors 13 to 15, and a plating process using nickel or the like may be provided on a surface of this metal. Here, each of the conductors 13 to 15 may also be configure of three or more conductors by being divided.

Various power devices such as an IGBT, a power MOSFET, a power BJT, a thyristor, a GTO thyristor, a SI thyristor and a diode can be used as the semiconductor element 106. The semiconductor element 106 may be bonded to the conductors 13 to 15 either directly or by further interposing a terminal plate, a buffer plate, or the like between the semiconductor element 106 and the conductors 13 to 15.

The bonding between the semiconductor element 106 and the conductors 13 to 15 may be established by use of a variety of solders, conductive paste, and the like.

In addition to the semiconductor element 106, various electronic components such as resistors, capacitors or coils, and circuits such as a power source may be mounted on this semiconductor device. Alternatively, the semiconductor device may be formed as a simple module that mounts only the power semiconductor element.

Meanwhile, this semiconductor device may include a control circuit such as an nMOS control circuit, a pMOS control circuit, a CMOS control circuit, a bipolar control circuit, a BiCMOS control circuit or a SIT control circuit. These control circuits may be configured to contain an overvoltage protection circuit, an overcurrent protection circuit, an overheat protection circuit, and the like.

Metal such as copper or a copper alloy, or a metallic material having excellent heat conductivity such as a metal-matrix composite is used as the heat sink plate 11.

Resin can be used as the insulator 12. For example, epoxy resin, phenol resin, urethane resin, silicone resin, and the like are suitable for the resin to be used as the insulator 12.

The heat conductive insulator 16 constituting the insulator 12 is formed by adding at least one of a hardening accelerator, a stress reducer, a filler, a solvent, a coupling agent to improve blending between the filler and the resin, a mold releasing agent to facilitate peeling a sheet, and a pigment, to resin such as epoxy resin, phenol resin, urethane resin or silicone resin. In this way, the heat conductivity of the heat conductive insulator 16 is made adjustable.

Meanwhile, the flexible insulator 17 constituting the insulator 12 is formed by adding at least one of a flame retardant, a solvent, a mold releasing agent, and a pigment, to flexible resin such as urethane resin or silicone resin. In this way, the elastic modulus, the hardening temperature, and the like of the flexible insulator 17 is made adjustable.

As the filler, it is possible to use any one of or a combination of inorganic fillers including silica, calcium carbonate, alumina, boron nitride, aluminum nitride, and the like, for example.

According to the semiconductor device of Embodiment 1, the heat generated by the semiconductor element 106 is transmitted from both surfaces of the semiconductor element 106 to the heat sink plate 11 through the conductors 13 to 15 that are bonded on both sides of the semiconductor element 106, as similar to the semiconductor device disclosed in JP-A 2005-348529. For this reason, it is possible to obtain thermal efficiency twice as large as that of the conventional typical semiconductor device shown in FIG. 1. Moreover, since a wire bonding process is not necessary, it is possible to reduce manufacturing time and to improve production yields. Further, it is possible to eliminate internal inductance attributable to wiring which is generated at wire bonding portions.

Moreover, according to the semiconductor device of Embodiment 1, out of the insulator 12 for bonding the conductors 13 to 15 to the heat sink plate 11, the outer peripheral portion of the conductors 13 to 15 where the stress becomes largest, i.e. the outside of the heat conductive insulator 16 is formed of the flexible insulator 17. For this reason, the stress acting on the insulator 12 is eased, and a radiation property is maintained at the remaining portion by the heat conductive insulator 16. As a result, the cooling performance equivalent to that achieved by the conventional semiconductor device disclosed in JP-A 2005-348529 is achieved while improving the durability against the stress at the time of operating the semiconductor device.

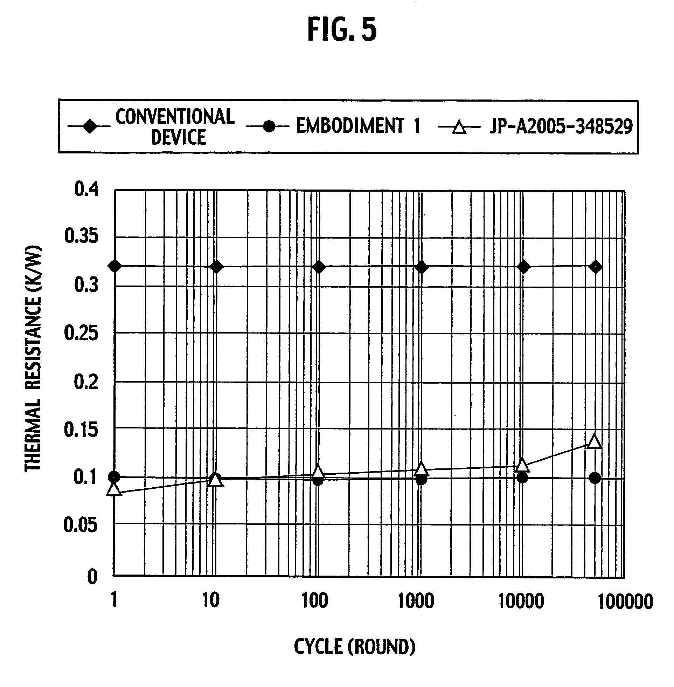

FIG. 5 is a graph showing comparison in terms of an energization cycle lives of the thermal resistance characteristics of the semiconductor devices among the conventional semiconductor device, the semiconductor device disclosed in JP-A 2005-348529, and the semiconductor device according to Embodiment 1. As apparent from FIG. 5, the semiconductor device according to Embodiment 1 of the present invention has drastically reduced thermal resistance and excellent reliability, as compared to the conventional typical semiconductor device and the semiconductor device disclosed in JP-A 2005-348529.

As described above, according to the semiconductor device of Embodiment 1 of the present invention, the cooling performance is improved, and the durability is improved. As a result, it is possible to enhance the reliability and thereby to achieve a higher performance and size reduction.

### (Embodiment 2)

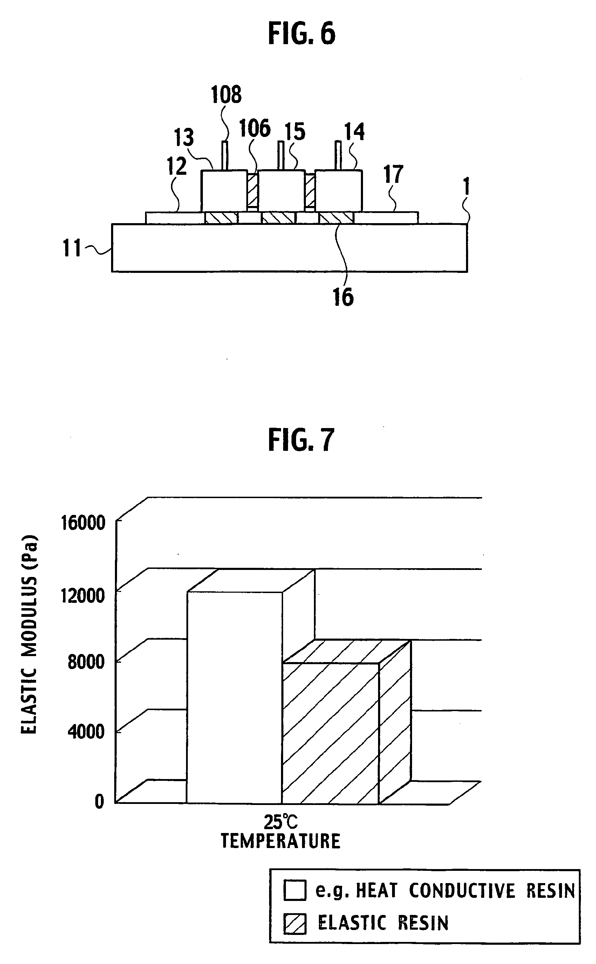

FIG. 6 is a cross-sectional view partially showing a structure of a semiconductor device according to Embodiment 2 of the present invention. The semiconductor device according to Embodiment 2 is different from that according to Embodiment 1 in the structure of the insulator 12. Specifically, in the insulator 12, multiple heat conductive insulators 16 are formed inside the portions respectively facing the conductors 13 to 15, and the flexible insulator 17 is formed at outer peripheral portions of the respective conductors 13 to 15, that is, at the portions excluding the heat conductive insulators 16.

Resin containing a heat conductive inorganic filler is used as the heat conductive insulators 16 constituting the insulator 12. For example, silica, calcium carbonate, alumina, boron nitride, aluminum nitride, and the like, are suitable for the heat conductive inorganic filler. The heat conductive inorganic filler may also be formed by combining these substances. Here, if importance is put on the heat conductivity, alumina, boron nitride, aluminum nitride, and the like are suitable.

Rubber-like elastic resin is used as the flexible insulator 17 constituting the insulator 12. For example, synthetic rubber, silicone resin, urethane resin, and the like are suitable for the elastic resin. Other configurations are similar to those in Embodiment 1, and description will therefore be omitted.

FIG. 7 is a graph showing comparison of elastic modulus characteristics between high heat conductive resin and the rubber-like elastic resin which are used as the insulator 12 in the semiconductor device according to Embodiment 2. As apparent from FIG. 7, the rubber-like elastic resin has a low elastic modulus as compared to the resin containing the heat conductive inorganic filler. Accordingly, the rubber-like elastic resin can reduce the stress generated by a deformative strain more.

As described above, according to the semiconductor device of Embodiment 2 of the present invention, it is possible to enhance the effect to ease the stress with the flexible insulator 17 as compared to the semiconductor device according to Embodiment 1.

### (Embodiment 3)

Embodiment 3 of the present invention is a method for manufacturing a semiconductor device. Here, an example of manufacturing the semiconductor device according to Embodiment 1 will be explained.

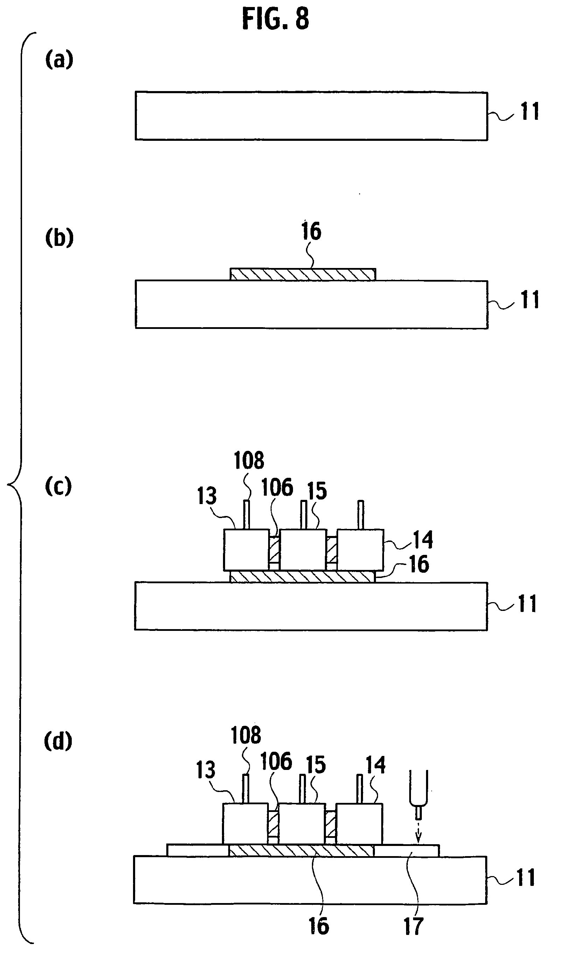

First, the heat sink plate 11 is prepared as shown in FIG. 8(a). Subsequently, as shown in FIG. 8(b), a heat conductive adhesive sheet serving as the heat conductive insulator 16 is placed on the heat sink plate 11. As for the heat conductive adhesive sheet, it is possible to use a prepreg sheet prepared by combining and semi-curing the resin such as epoxy resin and silicone resin with the heat conductive inorganic filler, for example. Here, the heat conductive adhesive sheet may also be formed by applying a combination of the resin such as epoxy resin and silicone resin with the heat conductive inorganic filler on the heat sink plate, for example.

Subsequently, as shown in FIG. 8(c), the component formed by bonding the conductors 13 to 15 to the semiconductor elements 106 is placed on the heat conductive adhesive sheet, and any one of or both of heating and pressurizing processes are performed. In this way, the heat sink plate 11 is attached to the multiple conductors 13 to 15 through the heat conductive insulator 16.

Subsequently, as shown in FIG. 8(d), liquid resin is injected to the outer peripheral portions of the multiple conductors 13 to 15 and is subjected to solidification or hardening to form the flexible insulator 17. Injection of the liquid resin can be performed by potting or other methods such as transfer molding or injection molding. Other configurations are similar to those in the semiconductor device according to Embodiment 1 or Embodiment 2, and description will therefore be omitted.

As described above, according to the method for manufacturing a semiconductor device of Embodiment 3, the heat sink plate 11 is attached to the multiple conductors 13 to 15 through the heat conductive insulator 16 by use of the adhesive sheet. Hence, the manufacturing process is simplified, and manufacturing time can be reduced. Accordingly, it is possible to improve mass productivity of the semiconductor device.

### (Embodiment 4)

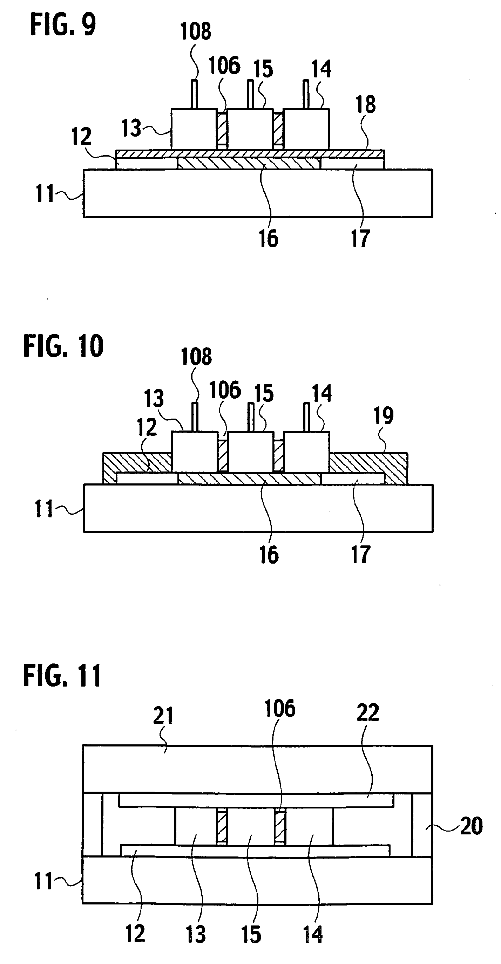

FIG. 9 is a cross-sectional view partially showing a structure of a semiconductor device according to Embodiment 4 of the present invention. This semiconductor device is formed by adding an adhesive resin layer 18 to a space between the insulator 12 and the conductors 13 to 15 of the semiconductor device according to Embodiment 1. As for the adhesive resin layer 18, it is possible to use the resin having the same composition as the insulator 12, for example. Alternatively, resin such an ethylene-methacrylate copolymer and phenoxy resin may also be used. The thickness of the adhesive resin layer 18 may be set in a range from 10 µm to 50 µm, for example. Other configurations are similar to those in the semiconductor device according to Embodiment 1, and description will therefore be omitted.

According to the semiconductor device of Embodiment 4, the provision of the adhesive resin layer 18 makes it possible to ease a difference in the state of stress on a junction interface between the multiple conductors 13 to 15 and the heat conductive insulator 16 and the flexible insulator 17, and thereby to establish uniformity as a whole. As a result, it is possible to improve the durability against a temperature cycle attributable to heat generation of the semiconductor element 106, an external environment, and the like, as well as the reliability.

### (Embodiment 5)

FIG. 10 is a cross-sectional view partially showing a structure of a semiconductor device according to Embodiment 5 of the present invention. This semiconductor device is formed by adding insulating resin 19 for covering and fixing the insulator 12 around the conductors 13 to 15 of the semiconductor device according to Embodiment 1.

The insulating resin 19 may be filled in a thickness sufficient to cover the surface of the insulator 12, or may be filled to cover the semiconductor element 106 and the conductors 13 to 15. A material suitable for the insulating resin 19 is resin (hard resin generally used as a sealing member) prepared by combining insulating resin such as epoxy resin as a base material, with a filler such as fused silica powder, quartz powder, glass powder or glass short fiber. The insulating resin 19 is filled by use of a dispenser or the like. Other configurations are similar to those in the semiconductor device according to Embodiment 1, and description will therefore be omitted.

According to the semiconductor device of Embodiment 5, it is possible to ease a heat stress generated by the heat generation of the semiconductor element 106 at the time of operation and to improve the durability against the temperature cycle attributable to the heat generation of the semiconductor element, the external environment, and the like as well as the reliability. Moreover, by insulating and sealing the insulator 12 and the conductors 13 to 15 by using the insulating resin 19, penetration of moisture or impurities from outside can be prevented. Accordingly, it is possible to improve moisture resistance and the reliability of the semiconductor device.

### (Embodiment 6)

FIG. 11 is a cross-sectional view partially showing a structure of a semiconductor device according to Embodiment 6 of the present invention. In this semiconductor device, a first heat sink plate 11 is bonded to the first insulator 12 by use of the conductor 13 to 15, and a second heat sink plate 21 and a second insulator 22 are disposed on an opposite surface while interposing the conductors 13 to 15. Further, the semiconductor device according to Embodiment 6 may also be configured so as to bond between the first heat sink plate 11 and the second heat sink plate 21 by use of a metal body 20. In this case, the metal body 20 serves as a radiator.

According to the semiconductor device of Embodiment 6, it is possible to further enhance cooling efficiency by radiating the heat generated by the semiconductor element 106 from both surfaces of the conductors 13 to 15. Moreover, it is possible to establish stress balance by a symmetric structure in which the conductors 13 to 15 are located in the center, and to suppress thermal deformations of the heat sink plates in the manufacturing process, at the time of operating the semiconductor device, and so forth. Moreover, it is possible to improve the durability against the temperature cycle attributable to heat generation of the semiconductor element at the time of operation, the external environment, and the like as well as the reliability.

### Industrial Applicability

The present invention is applicable to a small and lightweight semiconductor which is expected to achieve high conversion efficiency.

## Claims

1. A semiconductor device comprising:
a semiconductor element having a surface on a positive electrode side and a surface on a negative electrode side;
a plurality of conductors bonded respectively to the surface on the positive electrode side and to the surface on the negative electrode side of the semiconductor element;
a heat sink plate disposed as intersecting a junction interface between the semiconductor element and each of the plurality of conductors and configured to discharge heat of the semiconductor element; and
an insulator bonding the heat sink plate to the plurality of conductors,
wherein the insulator includes a heat conductive insulator disposed inside a portion facing all of the plurality of conductors and a flexible insulator disposed at a portion other than the heat conductive insulator.

2. The semiconductor device according to claim 1,
wherein the heat conductive insulator is made of resin containing a heat conductive inorganic filler, and
the flexible insulator is made of rubber-like elastic resin.

3. The semiconductor device according to claim 1, further comprising:
an adhesive resin layer between the insulator and the plurality of conductors.

4. The semiconductor device according to claim 1, further comprising:
insulating resin located around the plurality of conductors to cover and fix the insulator.

5. A semiconductor device comprising:
a semiconductor element having a surface on a positive electrode side and a surface on a negative electrode side;
a plurality of conductors bonded respectively to the surface on the positive electrode side and to the surface on the negative electrode side of the semiconductor element;
a first heat sink plate disposed as intersecting a junction interface between the semiconductor element and each of the plurality of conductors and configured to discharge heat of the semiconductor element;
a first insulator bonding the first heat sink plate to the plurality of conductors;
a second heat sink plate located opposite to the first heat sink plate with the plurality of conductors sandwiched therebetween, and configured to discharge heat of the semiconductor element; and
a second insulator bonding the second heat sink plate to the plurality of conductors.

6. The semiconductor device according to claim 5, further comprising:
a metal body connecting the first heat sink plate and the second heat sink plate so as to surround the plurality of conductors bonded to the semiconductor element.

7. A method of manufacturing a semiconductor device comprising:
a conductor bonding step of bonding a plurality of conductors respectively to a surface on a positive electrode side and a surface on a negative electrode side of a semiconductor element including the surface on the positive electrode side and the surface on the negative electrode side; and
an insulation bonding step of bonding a heat sink plate to the plurality of conductors by use of an insulator, the heat sink plate disposed as intersecting a junction interface between the semiconductor element and the plurality of conductors and configured to discharge heat of the semiconductor element, and the insulator including an adhesive sheet which constitutes a heat conductive insulator, and a flexible insulator,
wherein, in the insulation bonding step, after the plurality of conductors are attached, by use of the adhesive sheet, to the heat sink plate inside a portion in which all of the plurality of conductors face the heat sink plate, the flexible insulator is formed by injecting liquid resin to an outer peripheral portion of the adhesive sheet and by solidifying or hardening the liquid resin.
